# FASCICULE DE BREVET EUROPEEN

(11) **EP 2 361 004 B1**
(45) Date de publication et mention de la délivrance du brevet: **08.05.2013**
(21) Numéro de dépôt: 11155648.6
(22) Date de dépôt: 23.02.2011
(51) Int. Cl.: H05K 7/14

(54) **Socle pour carte électronique et dispositif d'extraction associé**
Einschubsockel und Herausziehvorrichtung für elektronische Karte
Base for electronic card and associated extraction device

(30) Priorité: 24.02.2010 FR 1051325
(43) Date de publication de la demande: 24.08.2011
(73) Titulaire: Airbus Operations, 31060 Toulouse (FR)
(72) Inventeur: Cologno, Emile, 31310 MONTESQUIEU VOLVESTRE (FR); Roujean, Olivier, 31200 TOULOUSE (FR)
(74) Mandataire: Petit, Maxime

(56) Documents cités:
- DE-A1- 2 525 618
- FR-A1- 2 580 434
- US-A1- 2003 172 523
- US-A1- 2007 111 574
- US-A1- 2007 236 899
- US-B1- 6 246 585
- US-B1- 6 317 967
- US-B1- 6 579 029

## Description

La présente invention concerne d'une manière générale les extracteurs de cartes électroniques.

Plus particulièrement, la présente invention concerne les extracteurs de cartes électroniques pour équipements avioniques d'un aéronef.

Les équipements avioniques d'un aéronef sont constitués de calculateurs prenant la forme de cartes électroniques montées dans des boîtiers ou cabinets, reliés au faisceau électrique de l'aéronef. En pratique, les cartes électroniques sont montées par l'une de leurs tranches dans une rainure prévue à cet effet sur un socle monté dans un boîtier. Le fond du boîtier présente une pluralité de connecteurs disposés perpendiculairement au socle, de manière à raccorder électriquement les cartes électroniques montées sur le socle par une tranche perpendiculaire et immédiatement voisine de la tranche montée dans la rainure du socle.

Habituellement, dans un dispositif classique comportant des cartes électroniques, pour démonter une carte électronique, il faut s'assurer d'avoir coupé l'alimentation électrique de la carte électronique pour éviter tout dommage aux composants électroniques avant d'actionner l'extracteur pour extraire la carte.

Dans les équipements avioniques, il existe des équipements modulaires dont l'un des objectifs recherchés est de conserver la disponibilité des différentes fonctions avioniques même lorsqu'une carte électronique donnée est démontée. Concrètement, il s'agit de pouvoir démonter les cartes indépendamment les unes des autres et de faire en sorte que l'équipement soit en mesure d'assurer une fonction donnée malgré l'absence d'une ou de plusieurs cartes électroniques.

En pratique, pour extraire une carte électronique, l'opérateur lance une requête en extraction sur un calculateur central pour une carte donnée. Les autres cartes sont alors reconfigurées pour pouvoir fonctionner sans la carte choisie et l'alimentation de cette dernière est coupée. Un indicateur visuel annonce à l'opérateur qu'il peut extraire la carte.

Cependant, il subsiste le risque que l'opérateur ne démonte pas la carte sur laquelle la requête d'extraction a été effectuée mais une autre carte. Une extraction erronée peut endommager la carte en question. De plus, des dysfonctionnements du système peuvent se produire puisque le système n'a pas été reconfiguré pour fonctionner sans la carte extraite par erreur.

Ainsi, le problème est de subordonner l'extraction de la carte à la préparation modulaire des autres cartes électroniques et à la coupure d'alimentation en courant de celle-ci.

Plus généralement, le problème est donc d'empêcher les extractions incorrectes ou erronées des cartes électroniques.

Pour être extraites, les cartes sont munies d'extracteurs en forme de levier permettant de démultiplier un effort d'extraction appliqué sur le levier pour contribuer à extraire la carte.

Le document US 6 579 029 décrit un dispositif de verrouillage multi-fonctions comprenant une base de verrouillage et un corps de verrouillage relié à la base de manière à pouvoir pivoter par rapport à celle-ci entre une position verrouillée et une position déverrouillée. Dans la position déverrouillée, le corps constitue un bras de levier pour insérer ou retirer un module de la base.

Le document US 6 317 967 décrit un équipement remplaçable en escale comprenant plusieurs cartes électroniques disposées dans des fentes et associées à des dispositifs d'insertion/extraction utilisant un agencement de type pignon-crémaillère de manière à obtenir une force d'insertion relativement élevée au cours d'un déplacement.

Le document DE 25 25618 décrit un dispositif électronique de don d'autorisation de déverrouillage de modules électroniques enfichables dans des racks qui est contrôlé par un organe de commande à distance.

En fait, l'évolution du nombre de composants sur les cartes électroniques a conduit à l'augmentation du nombre de contacts entre les cartes et leurs connecteurs. La pression de contact sur chacune des cartes est telle qu'il est nécessaire de prévoir un extracteur. En pratique, une extraction peut demander une force allant jusqu'à 350N. On comprend que sans l'aide d'un extracteur, il est impossible d'extraire la carte.

Partant de ces constatations, l'invention propose un socle pour carte électronique comportant au moins une rainure adaptée à recevoir une carte électronique avec un levier d'extraction monté à rotation par rapport à celle-ci et adapté à pivoter entre une première position et une seconde position, le levier présentant une extrémité d'appui adaptée à venir en appui sur un élément d'appui du socle pour extraire la carte électronique du socle lorsque le levier passe de la première à la seconde position, l'élément d'appui présentant un premier état dans lequel le levier d'extraction ne prend pas appui sur l'élément d'appui en passant de la première position à la seconde position, et un second état, dans lequel le levier prend appui sur l'élément en passant de la première à la seconde position, la rotation du levier de la première position vers la seconde position entraînant alors un mouvement d'extraction de la carte par appui de l'extrémité d'appui du levier sur l'élément d'appui suivant une direction d'appui.

Ainsi, l'invention propose de rendre inopérante la surface d'appui pour le levier d'extraction, de manière à rendre celui-ci inopérant faute de surface d'appui lorsque cela est nécessaire. En d'autres termes, l'efficacité du levier étant subordonnée à la présence d'une surface d'appui, le fait de rendre celle-ci inopérante, empêche l'actionnement du levier et s'oppose donc à toute extraction erronée de la carte.

Ceci garantit une plus grande fiabilité lors des interventions de maintenance.

Selon une caractéristique avantageuse possible de l'invention, l'élément d'appui est monté libre en translation selon la direction d'appui, et le passage du premier au second état est réalisé par un blocage mécanique de l'élément d'appui en translation dans une position dans laquelle l'extrémité d'appui du levier prend appui sur ledit élément lors de la rotation du levier de la première position vers la seconde position entraînant alors un mouvement d'extraction de la carte.

Ainsi, avantageusement, le nombre de pièces mécaniques en mouvement est limité.

Selon des caractéristiques avantageuses possibles de l'invention, éventuellement combinées :
- l'élément d'appui est mobile entre une première position dans laquelle il ne se trouve pas sur le chemin de l'extrémité d'appui du levier lorsque celui-ci passe de sa première à sa seconde position, et une seconde position dans laquelle l'élément d'appui est sur ledit chemin de l'extrémité d'appui du levier, le passage du premier au second état étant réalisé par un déplacement et un blocage mécanique de l'élément d'appui de ladite première position à ladite seconde position ;
- l'élément d'appui est mobile en translation selon la direction d'appui;
- l'élément d'appui est mobile selon une direction sensiblement perpendiculaire à la direction d'appui.
- le blocage mécanique est réalisé à l'aide d'un électroaimant ;

Selon un autre aspect, l'invention concerne un dispositif d'extraction comportant au moins une carte électronique présentant un levier présentant une extrémité d'appui adaptée à venir en appui sur un élément d'appui et un socle tel que décrit ci-dessus.

Selon un aspect avantageux, le dispositif d'extraction comporte des moyens visuels indiquant que l'élément d'appui est dans le second état.

Selon un autre aspect, l'invention concerne un dispositif d'extraction de carte électronique, comportant une pluralité de cartes reliées entre elles et des moyens de commande adaptés à :
- recevoir une requête d'extraction pour une carte donnée,
- reconfigurer les autres cartes afin d'assurer la ou les fonctions de la carte à extraire,
- envoyer un signal à l'élément d'appui de la carte sélectionnée pour passer du premier au second état,
- indiquer que la carte est prête à être extraite par un indicateur visuel.

Selon un autre aspect, l'invention concerne un procédé d'extraction d'une carte électronique à l'aide d'un dispositif d'extraction tel que décrit ci-dessus, comportant les étapes suivantes :
- lancement d'une requête d'extraction pour une carte donnée,
- identification que la carte est prête à être extraite à l'aide de l'indicateur visuel,
- extraction de la carte en faisant passer le levier de la première à la seconde position.

Selon un autre aspect, l'invention concerne un aéronef équipé d'un socle et/ou d'un dispositif d'extraction et /ou d'un dispositif de commande tel que décrit ci-dessus.

L'exposé de l'invention sera maintenant poursuivi par la description détaillée de deux exemples de réalisation, donnée ci-après à titre illustratif et non limitatif, en référence aux dessins annexés. Sur ceux-ci :
- les figures 1a à 1c montrent le principe de fonctionnement d'un levier d'extraction pour carte électronique d'une manière générale ;
- les figures 2a à 2c montrent le principe de fonctionnement d'un levier d'extraction pour carte électronique selon l'invention ;
- la figure 3 est une vue de côté d'un mode de réalisation alternatif d'un dispositif d'extraction pour carte électronique selon l'invention.
- la figure 4 est une vue de côté d'un autre mode de réalisation d'un dispositif d'extraction pour carte électronique selon l'invention.

D'une manière générale, les mêmes repères numériques sont utilisés dans la description des figures annexées pour des éléments identiques ou similaires.

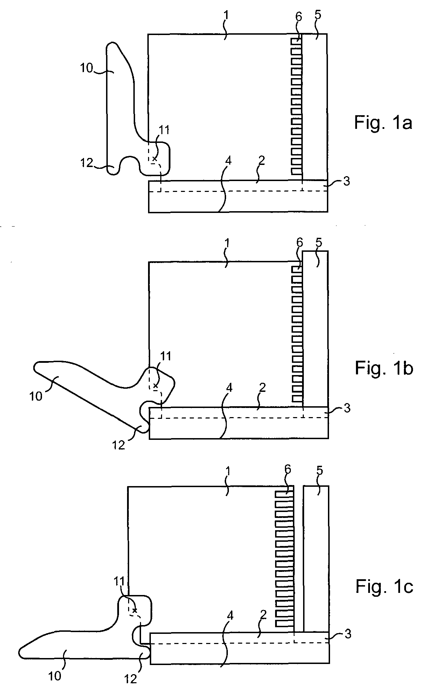

Les figures 1a, 1b et 1c représentent schématiquement en vue de côté, une carte électronique 1 montée par sa tranche inférieure dans une rainure 2 prévue à cet effet dans un socle 3 monté dans un boîtier 4. Le fond du boîtier 4 présente un connecteur 5 disposé perpendiculairement au socle dans le même plan que la rainure 2 de manière à raccorder électriquement les contacts électriques des cartes électroniques disposées sur une tranche perpendiculaire et immédiatement voisine de la tranche montée dans la rainure du socle.

Sur les figures 1a à 1c on a représenté les contacts électriques de la carte 1, les autres cartes non visibles étant montées parallèlement.

La carte 1 présente à l'extrémité opposée aux contacts électriques 6 un levier 10 monté à rotation sur la carte 1 par l'intermédiaire d'un pivot 11 perpendiculaire à la carte et à la direction longitudinale de celle-ci.

Comme visible plus particulièrement en figures 1b et 1c, lorsque le levier est pivoté autour du pivot 11 depuis une première position (figure 1 a) vers une seconde position (figure 1 c), une extrémité d'appui 12 du levier prend appui sur une face extérieure du socle 3 formant surface d'appui, en démultipliant la force appliquée à l'extrémité opposée du levier pour la transformer en effort d'extraction de la carte de son connecteur 5.

Les efforts de contact entre les contacts 6 et le connecteur 5 sont tels que l'utilisation d'un levier 10 d'extraction est nécessaire pour extraire la carte 1 du connecteur 5. L'invention tire profit de ce constat en proposant de prévoir ou non une surface d'appui pour le levier, autorisant ou interdisant ainsi l'extraction de la carte.

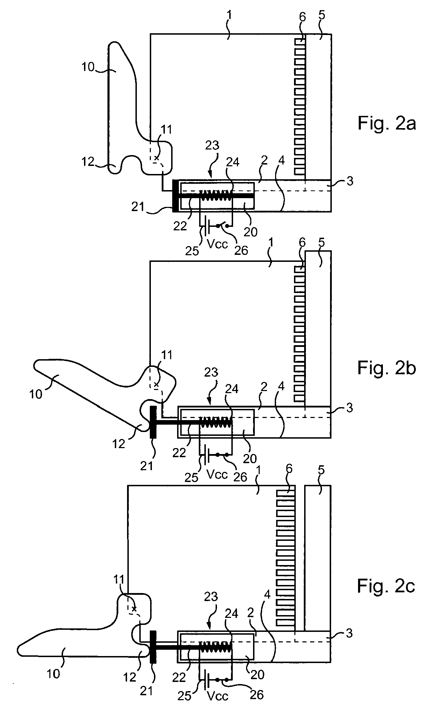

Un premier mode de réalisation d'un dispositif d'extraction selon l'invention est visible en figures 2a à 2c. Selon le même principe mécanique que sur les figures 1a à 1c, le dispositif d'extraction comporte un levier d'extraction 10 pour la carte électronique 1 monté selon le pivot 11 par rapport à la carte, de manière à ce qu'il puisse pivoter entre une première position et une seconde position. Le mouvement d'extraction de la carte est subordonné à la présence d'une surface d'appui pour l'extrémité d'appui du 12 du levier.

Comme visible en figures 2a à 2c, le socle selon l'invention présente un dispositif 20 d'appui. Celui-ci comporte une plaque d'appui 21 solidaire d'une tige 22 au moins partiellement ferromagnétique et montée à translation dans le socle 3 entre une première position rétractée telle que visible en figure 2a et une seconde position dite d'appui telle que visible en figures 2b et 2c. La translation depuis la première position vers la position d'appui est commandée par un électroaimant 23 composé de la partie ferromagnétique de la tige 22 sur laquelle est installée une bobine électrique 24 alimentée par un circuit électrique 25 soumis à une tension Vcc. Le circuit 25 peut être interrompu à l'aide d'un interrupteur 26. La partie ferromagnétique de la tige 22 et la bobine 24 forment conjointement un électroaimant.

Lorsque l'interrupteur 26 est fermé, la bobine 24 génère un champ électromagnétique agissant sur la partie ferromagnétique de la tige 22, le faisant ainsi passer de la position rétractée visible en figure 1 à la position d'appui visible en figure 2b dans laquelle la plaque d'appui 21 est avancée de manière à ce que l'extrémité 12 d'appui du levier 10 prenne appui sur la plaque d'appui. Le levier 10 entraîne alors un mouvement d'extraction de la carte lors de sa rotation autour du pivot 11 comme visible en figure 2c.

Ainsi, avantageusement, l'extraction de la carte étant subordonnée à la présence de la surface d'appui pour le levier 10, toute extraction intempestive est empêchée tant que l'élément d'appui 21 n'est pas dans la seconde position dite d'appui.

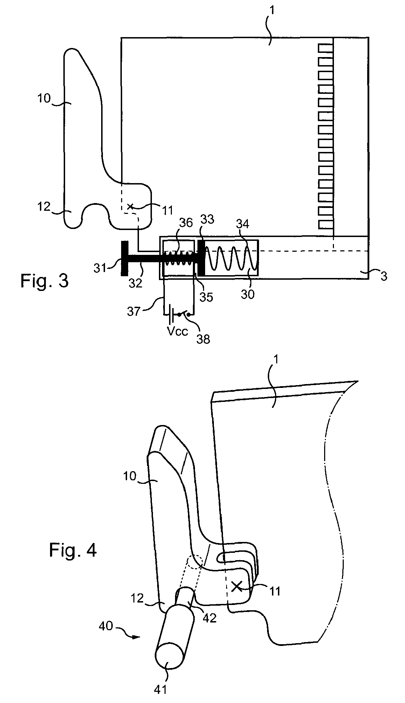

Un mode de réalisation alternatif est représenté en figure 3.

Selon le même principe qu'exposé en figures 2a à 2c, dans ce mode de réalisation, un dispositif d'appui 30 est installé dans le socle 3. Ce dispositif comporte une plaque d'appui 31 solidaire d'une tige 32 montée à translation dans le socle 3 et solidaire à son extrémité opposée d'une plaque de butée 33. Un ressort 34 vient appuyer sur la face libre de la plaque 33 de manière à venir plaquer celle-ci contre deux butées 35 faisant saillie du socle 3.

Suivant le même principe qu'exposé pour les figures 2a à 2c, la tige 32 présente une portion ferromagnétique autour de laquelle est installée une bobine électrique 36 reliée à un circuit électrique 37 soumis à une tension Vcc. Le circuit électrique 37 peut être interrompu à l'aide d'un interrupteur 38. La partie ferromagnétique de la tige 32 et la bobine 36 forment conjointement un électroaimant.

En fonctionnement, le dispositif 30 présente une position de repos telle que visible en figure 3, dans laquelle le ressort 34 vient plaquer la plaque de butée 33 contre les butées 35, la plaque d'appui 31 se trouvant alors dans une position dite d'appui pour l'extrémité 12 du levier 10. Si ce dernier venait à être abaissé alors que l'interrupteur 38 est ouvert, la plaque d'appui 31 se rétracterait dans le dispositif 30 en comprimant le ressort 34. Le levier d'extraction ne prendrait alors pas appui sur la plaque d'appui 31 et il n'y aurait pas d'effet de mouvement d'extraction de la carte faute de surface d'appui.

Lorsque l'interrupteur 38 est fermé, la bobine 36 génère un champ électromagnétique autour de la partie ferromagnétique de l'arbre 32, bloquant ainsi en translation l'ensemble, ce qui rend immobile la plaque d'appui 31. Le levier 10 peut alors être abaissé jusqu'à ce que son extrémité d'appui 12 vienne en appui sur la plaque d'appui 31 désormais immobilisée, et il entraîne alors un mouvement d'extraction de la carte par appui sur cette plaque de manière analogue à l'extraction illustrée en figures 2b et 2c.

Le ressort 34 et la bobine 36 formant électroaimant avec l'arbre 32, sont dimensionnés de manière à ce qu'une tension minimale soit nécessaire pour bloquer la translation de l'ensemble lorsque l'interrupteur 38 est fermé.

Un autre mode de réalisation est schématiquement représenté en figure 4. Dans ce mode de réalisation, une carte électronique 1 en tous points similaire aux cartes électroniques telles que décrites ci-dessus et présentant un levier 10 avec une extrémité d'appui 12 est adapté à coopérer avec un mécanisme de verrouillage 40. Celui-ci présente un verrou 41 fixé à un socle non représenté, et dans lequel une rainure est prévue pour recevoir la carte électronique 1 de manière analogue aux modes de réalisation décrits ci-dessus. Il s'agit d'un verrou électromagnétique relié à un circuit électrique, non représenté, et en tous points similaire au circuit électrique décrit ci-dessus. Le verrou électromagnétique 41 présente une pige 42 commandée en translation par un électroaimant représenté disposé à l'intérieur du verrou. L'ensemble 40 est fixé sur le socle (non représenté) à hauteur de la portion d'appui 12 du levier, lorsque la carte 1 y est insérée. La pige est adaptée à se translater entre une première position dans laquelle elle est rétractée entièrement dans le corps du verrou 41 et une seconde position, telle que représentée en figure 4, dans laquelle la pige se trouve sur le chemin de l'extrémité d'appui 12 lorsque le levier pivote autour du pivot 11. La pige 42 sert alors d'élément d'appui pour l'extrémité d'appui 12 du levier entraînant alors un mouvement d'extraction de la carte de manière analogue à l'extraction représentée en figures 2b et 2c. Dans un mode de réalisation non représenté, le verrou est fixé dans un usinage prévu à cet effet sur le socle.

Selon un aspect avantageux de l'invention susceptible de s'appliquer à l'ensemble des modes de réalisation décrits ci-dessus, dans un dispositif comportant une pluralité de cartes électroniques reliées entre elles (non représenté) des moyens d'indication visuels sont prévus sur la carte ou à proximité de celle-ci pour indiquer à l'opérateur que les moyens d'appui sont activés. Il s'agit par exemple d'une diode électroluminescente reliée au circuit d'alimentation de l'électroaimant et qui indique si celui-ci est sous tension.

Selon les modes de réalisation, l'opérateur sait, selon que la diode est allumée ou éteinte, si la carte est prête à être extraite.

En pratique, les interrupteurs des circuits d'alimentation des modes de réalisation de l'invention décrits ci-dessus sont commandés par un dispositif de commande pour l'extraction des cartes électroniques. Dans un dispositif comportant une pluralité de cartes électroniques reliées entre elles (non représenté), ce dispositif de commande est adapté à recevoir de l'opérateur une requête d'extraction pour une carte électronique donnée, et à reconfigurer ensuite les autres cartes de manière à ce que celles-ci assurent la ou les fonctions de la carte à extraire. Le dispositif envoie ensuite un signal à l'interrupteur correspondant de la carte pour activer les moyens d'appui et les faire passer à un état dans lequel le levier prend appui sur l'élément d'appui. En parallèle, si un indicateur visuel est présent, celui-ci est basculé vers un état dans lequel il indique à l'opérateur que la carte choisie est prête à être extraite.

En pratique, l'opérateur lance une requête d'extraction pour une carte donnée sur le dispositif de commande. Il identifie ensuite que la carte en question est prête à être extraite à l'aide de l'indicateur visuel et, les moyens d'appui étant activés, il agit sur le levier de manière à le faire passer de la première à la seconde position telles que décrites ci-dessus afin d'extraire la carte en question.

De nombreuses autres variantes sont possibles en fonction des circonstances, et l'on rappelle à cet égard que l'invention ne se limite pas aux exemples décrits et représentés.

## Revendications

1. Socle (3) pour carte électronique (1) comportant au moins une rainure (2) adaptée à recevoir une carte électronique avec un levier d'extraction monté à rotation par rapport à celle-ci et adapté à pivoter entre une première position et une seconde position, le levier présentant une extrémité d'appui (12) adaptée à venir en appui sur un élément d'appui (21, 31, 42) du socle 3 pour extraire la carte électronique du socle lorsque le levier passe de la première à la seconde position, **caractérisé en ce que** l'élément d'appui (21, 31, 42) présente un premier état dans lequel le levier d'extraction (10) ne prend pas appui sur l'élément d'appui (21, 31, 42) en passant de la première position à la seconde position, et un second état, dans lequel le levier prend appui sur l'élément (21, 31, 42) en passant de la première à la seconde position, la rotation du levier de la première position vers la seconde position entraînant alors un mouvement d'extraction de la carte (1) par appui de l'extrémité d'appui (12) du levier (10) sur l'élément d'appui (21, 31, 42) suivant une direction d'appui.

2. Socle selon la revendication précédente, **caractérisé en ce que** l'élément d'appui (21, 31) est monté libre en translation selon la direction d'appui, et le passage du premier au second état est réalisé par un blocage mécanique de l'élément d'appui en translation dans une position dans laquelle l'extrémité d'appui (12) du levier prend appui sur ledit élément (21) lors de la rotation du levier (10) de la première position vers la seconde position entraînant alors un mouvement d'extraction de la carte (1).

3. Socle selon la revendication 1, **caractérisé en ce que** l'élément d'appui est mobile entre une première position dans laquelle il ne se trouve pas sur le chemin de l'extrémité d'appui (12) du levier (10) lorsque celui-ci passe de sa première à sa seconde position, et une seconde position dans laquelle l'élément d'appui (21, 31, 42) est sur ledit chemin de l'extrémité d'appui du levier, et **en ce que** le passage du premier au second état est réalisé par un déplacement et un blocage mécanique de l'élément d'appui (21, 31, 42) de ladite première position à ladite seconde position.

4. Socle selon la revendication 2, **caractérisé en ce que** l'élément d'appui (21, 31) est mobile en translation selon la direction d'appui.

5. Socle selon la revendication 3, **caractérisé en ce que** l'élément d'appui (42) est mobile selon une direction sensiblement perpendiculaire à la direction d'appui.

6. Socle selon l'une quelconque des revendications précédentes, **caractérisé en ce que** le blocage mécanique est réalisé à l'aide d'un électroaimant (22, 24, 32, 36, 41).

7. Dispositif d'extraction comportant au moins une carte électronique (1) présentant un levier (10) présentant une extrémité d'appui adaptée à venir en appui sur un élément d'appui et comportant un socle selon l'une quelconque des revendications précédentes présentant un tel élément d'appui (21, 31, 42).

8. Dispositif d'extraction selon la revendication précédente, **caractérisé en ce que** l'élément d'appui (21, 31, 42) est dans le second état.

9. Dispositif d'extraction selon la revendication 7 ou 8, comportant une pluralité de cartes électroniques reliées entre elles, **caractérisé en ce qu'**il comporte des moyens de commande adaptés à :
- recevoir une requête d'extraction pour une carte (1) donnée,
- reconfigurer les autres cartes afin d'assurer la ou les fonctions de la carte à extraire,
- envoyer un signal à l'électroaimant (22, 24, 32, 36, 41) de la carte sélectionnée pour passer du premier au second état,
- indiquer que la carte est prête à être extraite par un indicateur visuel.

10. Procédé d'extraction d'une carte électronique à l'aide d'un dispositif d'extraction selon la revendication précédente, **caractérisé en ce qu'**il comporte les étapes suivantes :
- lancement d'une requête d'extraction pour une carte (1) donnée,
- identification que la carte est prête à être extraite à l'aide de l'indicateur visuel,
- extraction de la carte en faisant passer le levier (10) de la première à la seconde position.

11. Aéronef équipé d'un socle (3) selon l'une quelconque des revendications 1 à 6 et/ou d'un dispositif d'extraction selon l'une quelconque des revendications 7 à 9.

## Patentansprüche

1. Sockel (3) für elektronische Karte (1), umfassend wenigstens eine Nut (2), die dazu ausgelegt ist, eine elektronische Karte aufzunehmen, mit einem Auszughebel, der ihr gegenüber drehbar angebracht und dazu ausgelegt ist, zwischen einer ersten Position und einer zweiten Position zu verschwenken, wobei der Hebel ein Anlageende (12) aufweist, das dazu ausgelegt ist, an einem Anlageelement (21, 31, 42) des Sockels (3) in Anlage zu kommen, um die elektronische Karte aus dem Sockel herauszuziehen, wenn der Hebel von der ersten in die zweite Position übergeht, **dadurch gekennzeichnet, dass** das Anlageelement (21, 31, 42) einen ersten Zustand aufweist, in dem sich der Auszughebel (10) beim Übergang von der ersten Position in die zweite Position nicht an dem Anlageelement (21, 31, 42) abstützt, sowie einen zweiten Zustand, in dem sich der Hebel beim Übergang von der ersten in die zweite Position an dem Element (21, 31, 42) abstützt, wobei die Drehung des Hebels von der ersten Position zur zweiten Position dann zu einer Herausziehbewegung der Karte (1) durch Anlage des Anlageendes (12) des Hebels (10) an dem Anlageelement (21, 31, 42) in einer Anlagerichtung führt.

2. Sockel nach dem vorhergehenden Anspruch, **dadurch gekennzeichnet, dass** das Anlageelement (21, 31) in der Anlagerichtung frei verschiebbar angebracht ist und der Übergang von dem ersten in den zweiten Zustand vollzogen wird durch ein mechanisches Festlegen des Anlageelements gegen ein Verschieben in einer Position, in der sich das Anlageende (12) des Hebels beim Drehen des Hebels (10) von der ersten Position zur zweiten Position an dem Element (21) abstützt, was dann zu einer Herausziehbewegung der Karte (1) führt.

3. Sockel nach Anspruch 1, **dadurch gekennzeichnet, dass** das Anlageelement zwischen einer ersten Position, in der es sich nicht auf dem Weg des Anlageendes (12) des Hebels (10), wenn dieser von seiner ersten in seine zweite Position übergeht, befindet, sowie einer zweiten Position, in der das Anlageelement (21, 31, 42) sich auf dem Weg des Anlageendes des Hebels befindet, beweglich ist, und dass der Übergang von dem ersten in den zweiten Zustand durch eine Bewegung und ein mechanisches Festlegen des Anlageelements (21, 31, 42) von der ersten Position in die zweite Position vollzogen wird.

4. Sockel nach Anspruch 2, **dadurch gekennzeichnet, dass** das Anlageelement (21, 31) in der Anlagerichtung verschiebebeweglich ist.

5. Sockel nach Anspruch 3, **dadurch gekennzeichnet**, das Anlageelement (42) in einer zu der Anlagerichtung im Wesentlichen senkrechten Richtung beweglich ist.

6. Sockel nach einem der vorhergehenden Ansprüche, **dadurch gekennzeichnet, dass** das mechanische Festlegen mit Hilfe eines Elektromagneten (22, 24, 32, 36, 41) vollzogen wird.

7. Ausziehvorrichtung, die wenigstens eine elektronische Karte (1) umfasst, mit einem Hebel (10), der ein Anlageende aufweist, das dazu ausgelegt ist, an einem Anlageelement in Anlage zu kommen, sowie einen Sockel nach einem der vorhergehenden Ansprüche, der ein solches Anlageelement (21, 31, 42) aufweist, umfasst.

8. Ausziehvorrichtung nach dem vorhergehenden Anspruch, **dadurch gekennzeichnet, dass** das Anlageelement (21, 31, 42) sich in dem zweiten Zustand befindet.

9. Ausziehvorrichtung nach Anspruch 7 oder 8, die eine Vielzahl von untereinander verbundenen elektronischen Karten umfasst, **dadurch gekennzeichnet, dass** sie Steuermittel umfasst, die dazu ausgelegt sind:
- eine Herausziehanfrage für eine gegebene Karte (1) zu empfangen,
- die anderen Karten neu zu konfigurieren, um die Funktion oder Funktionen der herauszuziehenden Karte sicherzustellen,
- ein Signal an den Elektromagneten (22, 24, 32, 36, 41) der ausgewählten Karte zu senden, um von dem ersten in den zweiten Zustand überzugehen,
- durch eine visuelle Anzeige anzuzeigen, dass die Karte bereit ist, herausgezogen zu werden.

10. Verfahren zum Herausziehen einer elektronischen Karte mit Hilfe einer Ausziehvorrichtung nach dem vorhergehenden Anspruch, **dadurch gekennzeichnet, dass** es die folgenden Schritte umfasst:
- Senden einer Herausziehanfrage für eine gegebene Karte (1),
- mit Hilfe der visuellen Anzeige feststellen, dass die Karte bereit ist, herausgezogen zu werden,
- Herausziehen der Karte durch Überführen des Hebels (10) von der ersten in die zweite Position.

11. Luftfahrzeug, das mit einem Sockel (3) nach einem der Ansprüche 1 bis 6 und/oder mit einer Ausziehvorrichtung nach einem der Ansprüche 7 bis 9 ausgestattet ist.

## Claims

1. Base (3) for an electronic card (1) comprising at least one slot (2) adapted for accommodating an electronic card with an extraction lever installed rotatably in relation thereto and adapted for pivoting between a first position and a second position, the lever having a support end (12) adapted for coming to rest on a support element (21, 31, 42) of the base 3 in order to extract the electronic card from the base when the lever changes over from the first to the second position, **characterized in that** the support element (21, 31, 42) has a first state in which the extraction lever (10) does not bear on the support element (21, 31, 42) when changing over from the first position to the second position, and a second state, in which the lever bears on the element (21, 31, 42) when changing over from the first to the second position, the rotation of the lever from the first position to the second position then bringing about a movement for extraction of the card (1) through support of the support end (12) of the lever (10) on the support element (21, 31, 42) along a support direction.

2. Base according to the preceding claim, **characterized in that** the support element (21, 31) is installed free in translation along the support direction, and the changeover from the first to the second state is accomplished by a mechanical blockage of the support element in translation in a position in which the support end (12) of the lever bears on the said support element (21) during rotation of the lever (10) from the first position to the second position then bringing about a movement for extraction of the card (1).

3. Base according to claim 1, **characterized in that** the support element is movable between a first position in which it is not in the path of the support end (12) of the lever (10) when the latter changes over from its first to its second position, and a second position in which the support element (21, 31, 42) is in the said path of the support end of the lever, and **in that** the changeover from the first to the second state is accomplished by a movement and a mechanical blockage of the support element (21, 31, 42) from the said first position to the said second position.

4. Base according to claim 2, **characterized in that** the support element (21, 31) is movable in translation along the support direction.

5. Base according to claim 3, **characterized in that** the support element (42) is movable along a direction more or less perpendicular to the support direction.

6. Base according to any one of the preceding claims, **characterized in that** the mechanical blockage is accomplished with the aid of an electromagnet (22, 24, 32, 36, 41).

7. Extraction device comprising at least one electronic card (1) having a lever (10) having a support end adapted for coming to rest on a support element and comprising a base according to any one of the preceding claims having such a support element (21, 31, 42).

8. Extraction device according to the preceding claim, **characterized in that** the support element (21, 31, 42) is in the second state.

9. Extraction device according to claim 7 or 8, comprising a plurality of interconnected electronic cards, **characterized in that** it comprises control means adapted for:
- receiving an extraction request for a given card (1),
- reconfiguring the other cards so as to provide the function or functions of the card to be extracted,
- sending a signal to the electromagnet (22, 24, 32, 36, 41) of the selected card to change over from the first to the second state,
- indicating by a visual indicator that the card is ready to be extracted.

10. Method for extraction of an electronic card with the aid of an extraction device according to the preceding claim, **characterized in that** it comprises the following steps:
- sending out an extraction request for given card (1),
- identifying with the aid of the visual indicator that the card is ready to be extracted,
- extracting the card by causing the lever (10) to change over from the first to the second position.

11. Aircraft equipped with a base (3) according to any one of claims 1 to 6 and/or with an extraction device according to any one of claims 7 to 9.
